# EUROPÄISCHE PATENTSCHRIFT

(11) **EP 0 546 251 B1**
(45) Veröffentlichungstag und Bekanntmachung des Hinweises auf die Patenterteilung: **23.10.1996**
(21) Anmeldenummer: 92112025.9
(22) Anmeldetag: 15.07.1992
(51) Int. Cl.: C23C 14/34, G11B 5/84, H01J 37/34

(54) **Kathodenzerstäubungsanlage**
Cathodic sputtering apparatus
Dispositif de polarisation cathodique

(30) Priorität: 11.12.1991 DE 4140862
(43) Veröffentlichungstag der Anmeldung: 16.06.1993
(73) Patentinhaber: Balzers und Leybold Deutschland Holding Aktiengesellschaft, 63450 Hanau (DE)
(72) Erfinder: Zejda, Jaroslav, Dipl.-Ing., W-6458 Rodenbach 1 (DE)
(74) Vertreter: Schlagwein, Udo, Dipl.-Ing.

(56) Entgegenhaltungen:
- EP-A- 0 297 521
- EP-A- 0 416 241
- FR-A- 2 528 452

## Beschreibung

Die Erfindung betrifft eine Kathodenzerstäubungsanlage mit zumindest einer von einem Außengehäuse begrenzten, als Vakuumkammer ausgebildeten, zumindest eine Kathode mit einem Target aufweisenden Kathodenstation, in welcher ein Substrathalter zum Halten eines zu beschichtenden Substrats, beispielsweise einer Datenspeicherdisk, angeordnet ist und die zumindest einen Gaseinlaß und zumindest einen mit einer Vakuumpumpe zu verbindenden Gasauslaß aufweist.

Eine Kathodenzerstäubungsanlage der vorstehenden Art ist beispielsweise in der US-A-4,558,388 beschrieben. Bei ihr wird ein Substrat in der Kathodenstation mittig auf einer Achse gehalten, auf der zu beiden Seiten des Substrats jeweils eine Kathode mit einem Target angeordnet ist, um beide Seiten des Substrats gleichzeitig durch Sputtern zu beschichten. Zur Erzeugung des notwendigen Vakuums ist im Außengehäuse der Kathodenstation quer zu der durch die Kathoden führenden Achse ausgerichtet ein mit einer Vakuumpumpe verbundener Gasauslaß vorgesehen. An einer Stirnseite des Außengehäuses befindet sich oberhalb der Kathode der Gaseinlaß.

Substrate müssen meist äußerst gleichmäßig beschichtet werden. Bei Datenspeicherdisks beträgt beispielsweise die Stärke der aufgebrachten Aluminiumschicht weniger als ein zehntausendstel Millimeter. Eine Ungleichförmigkeit der Beschichtung führt zu einer Verminderung der Speicherplätze für die zu speichernden, digitalen Informationen.

Um die angestrebte Gleichförmigkeit der Beschichtung zu erreichen, hat man bei den bekannten Kathodenzerstäubungsanlagen in erster Linie dafür gesorgt, daß das Substrat exakt zur Kathode und dem Target ausgerichtet ist und die physikalischen Bedingungen, welche den Ablauf des Sputterprozesses beeinflussen, möglichst optimal und gleichförmig sind.

Der Erfindung liegt das Problem zugrunde, eine Kathodenzerstäubungsanlage der eingangs genannten Art so auszubilden, daß sich die Gleichförmigkeit der Beschichtung der Substrate im Vergleich zu den bekannten Kathodenzerstäubungsanlagen noch weiter erhöhen läßt.

Dieses Problem wird erfindungsgemäß dadurch gelöst, daß der Gaseinlaß, der Substrathalter und der Gasauslaß auf einer gemeinsamen Achse oder daß mehrere Gaseinlässe und/oder Gasauslässe symmetrisch zu der Achse des Substrathalters angeordnet sind.

Durch diese Gestaltung ergibt sich ein sehr gleichmäßiger Druck in der Kathodenstation. Auf jeden Fall ist sichergestellt, daß in gleichen Abständen von der Achse des Substrates überall absolut gleiche Drücke herrschen. Diese konzentrische Druckgleichmäßigkeit in Verbindung mit der auch insgesamt großen Gleichförmigkeit des Druckes führt zu einem besonders gleichmäßigen Ablauf des Sputtervorganges und damit zu einer gleichmäßigen Beschichtung des Substrates. Die erfindungsgemäße Kathodenzerstäubungsanlage ist deshalb insbesondere für die Beschichtung von Compact Disks, magnetic Disks und optomagnetischen Disks geeignet.

Wenn Substrate gleichzeitig auf beiden Seiten beschichtet werden sollen, dann kann man gemäß einer vorteilhaften Weiterbildung der Erfindung in der Kathodenstation zu beiden Seiten des Substrathalters jeweils eine Kathode mit einem Target versehen.

Die zum raschen Absaugen der Kathodenstation erforderlichen großen Strömungsquerschnitte und ein gleichmäßiger Gaszutritt lassen sich auf einfache Weise dadurch erreichen, daß zwischen einer Außenmaskierung der Kathode und dem Außengehäuse ein zum vom Substrathalter gehaltenen Substrat führender, ringförmiger Strömungskanal gebildet ist.

Das zugeführte Gas wird zwangsläufig durch die Außenmaskierung zum Substrat hin umgelenkt, wenn gemäß einer besonders vorteilhaften Weiterbildung der Erfindung für die Gaszuführung innerhalb der Kathodenstation zusätzlich zum Strömungskanal auf der Außenseite der Kathodenmaskierung zwischen der Kathode und der Kathodenmaskierung ein innerer Strömungskanal gebildet ist.

Das zuströmende Gas gelangt optimal zunächst auf den mittleren Bereich des Substrats und verteilt sich dann gleichmäßig zur Peripherie hin, wenn gemäß einer anderen Ausgestaltung der Erfindung mittig durch die Kathode und ihrem Target hindurch eine mit dem Gaseinlaß strömungsmäßig verbundene Gaszuführbohrung verläuft.

Auch bei einer solchen mittigen Gaszufuhr kann man für große Absaugquerschnitte für den Raum hinter der Kathode sorgen, indem der Gaseinlaß mit der Gaszuführbohrung und den ringförmigen Strömungskanälen Verbindung hat.

Zur weiteren Vergleichmäßigung der Verteilung des zugeführten Gases trägt es bei, wenn koaxial zur Achse auf einem gemeinsamen Teilkreis zwischen dem Target und dem Substrathalter mehrere Gasauslässe vorgesehen sind.

Eine solche Gaszuführung über mehrere Gasauslässe ist konstruktiv besonders einfach, wenn die Gasauslässe an einer koaxial zur Achse angeordneten Ringleitung vorgesehen sind.

Die Ringleitung ist mit geringem Aufwand zu verwirklichen, wenn die Gasauslässe an einem koaxial zur Achse auf der Innenmantelfläche der Außenmaskierung ausgebildeten Ringkanal vorgesehen sind.

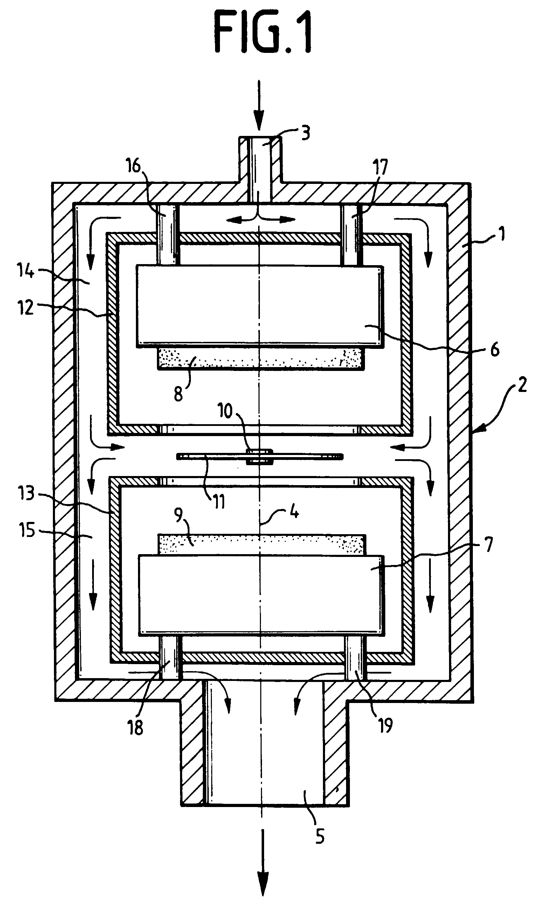

Die Erfindung läßt zahlreiche Ausführungsformen zu. Zur weiteren Verdeutlichung ihres Grundprinzips sind vier davon schematisch in der Zeichnung dargestellt und werden nachfolgend beschrieben. Diese zeigt in den Figuren 1 - 4 jeweils einen Längsschnitt durch eine Ausführungsform der Erfindung.

Die Figur 1 zeigt im Schnitt eine von einem Außengehäuse 1 begrenzte Kathodenstation 2, welche vorzugsweise kreisförmigen Querschnitt hat. Das Außengehäuse 1 weist an einer Stirnseite einen Gaseinlaß 3 und fluchtend hierzu auf einer gemeinsamen Achse 4 an der gegenüberliegenden Stirnseite einen Gasauslaß 5 mit im Vergleich zum Gaseinlaß 3 wesentlich größerem Querschnitt auf. Dieser Gasauslaß 5 ist mit einer nicht gezeigten Vakuumpumpe zu verbinden.

Im Inneren der Kathodenstation 2 sind koaxial zur Achse 4 zwei Kathoden 6, 7 mit jeweils einem Target 8, 9 angeordnet. Zwischen den Targets 8, 9 befindet sich auf der Achse 4 ein Substrathalter 10, welcher ein zu beschichtendes Substrat 11 - bei diesem Ausführungsbeispiel eine Datenspeicherplatte - haltert. Beide Kathoden 6, 7 mit dem jeweiligen Target 8, 9 sind von jeweils einer Außenmaskierung 12, 13 umgeben.

Die Außenmaskierungen 12, 13 lassen jeweils zwischen ihrer Außenmantelfläche und dem Außengehäuse 1 einen ringförmigen Strömungskanal 14, 15 frei. Die Kathoden 6, 7 sind durch Isolatoren 16, 17, 18, 19 mit Abstand zum Außengehäuse 1 gehalten. Deshalb vermag das durch den Gaseinlaß 3 einströmende Gas auf den durch Pfeile gekennzeichneten Wegen an den Außenseiten der Außenmaskierung 12, 13 vorbei zum Substrat 11 und dann auf entsprechendem Wege zum Gasauslaß 5 zu strömen.

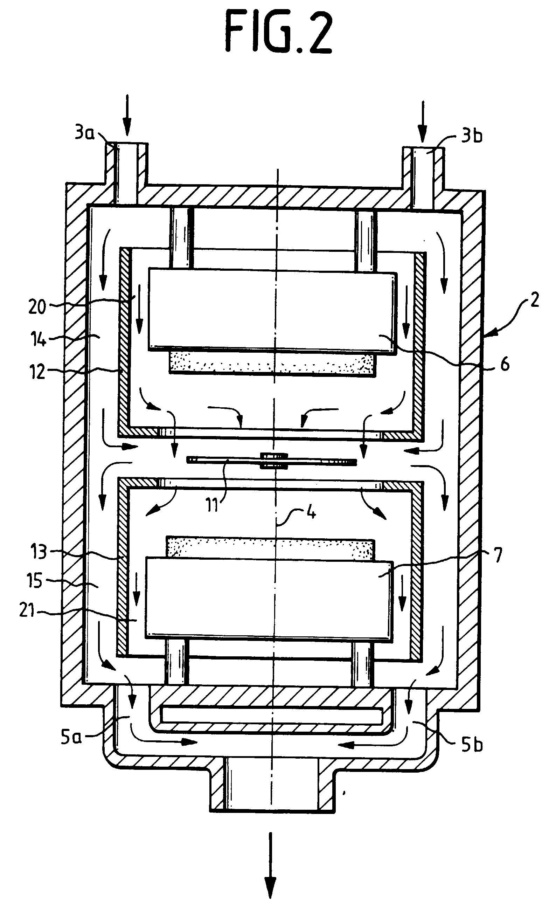

Bei der Ausführungsform nach Figur 2 sind in der in der Figur 2 gesehen oberen Stirnfläche der Kathodenstation 2 auf einem gemeinsamen, koaxial zur Achse 4 verlaufenden Teilkreis gleichmäßig verteilt mehrere Gaseinlässe 3a, 3b und entsprechend in der unteren Stirnfläche auf einem gemeinsamen Teilkreis gleichmäßig verteilt mehrere Gasauslässe 5a, 5b vorgesehen. Weiterhin decken bei dieser Ausführungsform im Gegensatz zu der nach Figur 1 die Außenmaskierungen 12, 13 die Kathoden 6, 7 nicht zu den Gaseinlässen 3a, 3b bzw. den Gasauslässen 5a, 5b ab. Dadurch entstehen zusätzlich zu den äußeren Strömungskanälen 14, 15 jeweils zwischen der Kathode 6, 7 und der Innenseite der Außenmaskierung 12, 13 innere, ringförmige Strömungskanäle 20, 21, über welche symmetrisch Gas zur Mitte des Substrates 11 zu strömen vermag. Anzumerken ist, daß diese inneren Strömungskanäle 20, 21 sich günstiger auswirken, wenn die Kathodenstation 2 wie in Figur 1 nur einen Gaseinlaß 3 und nur einen Gasauslaß 5 hat.

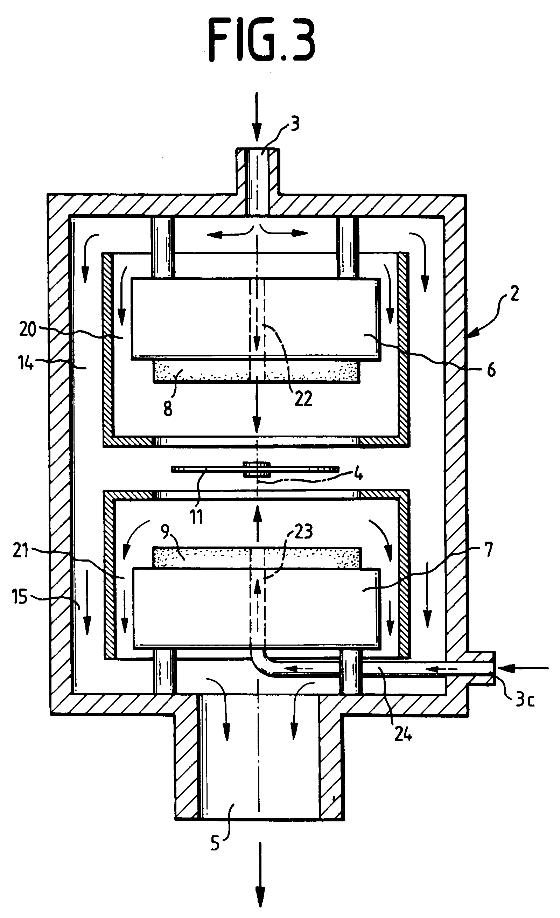

Bei der Ausführungsform nach Figur 3 führt jeweils koaxial durch die Kathoden 6, 7 und ihrem jeweiligen Target 8, 9 eine Gaszuführbohrung 22, 23. Durch die Gaszuführbohrung 22 kann ein Teilgasstrom vom Gaseinlaß 3 auf direktem Wege zu einer Seite des Substrates 11 gelangen. Durch die Gaszuführbohrung 23 strömt Gas zur anderen Seite des Substrates 11 von einem zweiten Gaseinlaß 3c über eine Leitung 24.

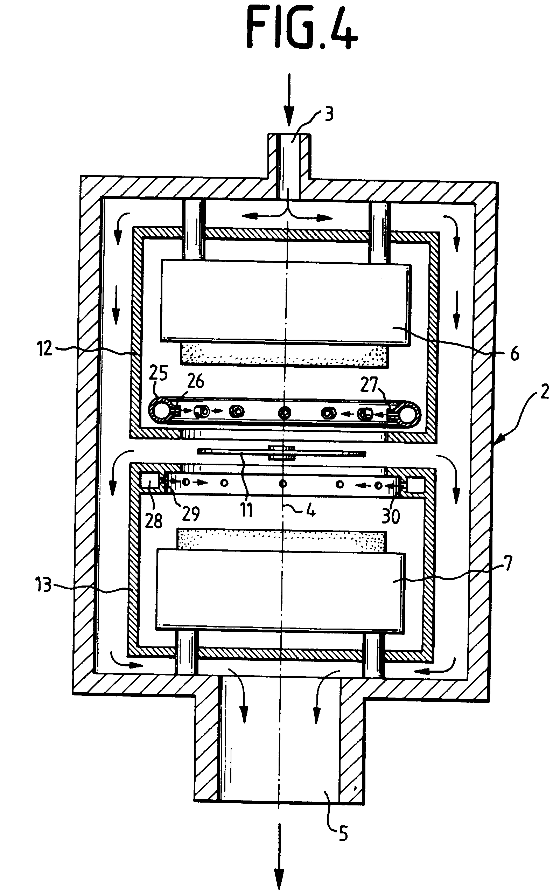

In Figur 4 ist im oberen Teil der Kathodenstation 2 innerhalb der Außenmaskierung 12 eine Ringleitung 25 angeordnet, welche über ihren Umfang gleichmäßig verteilt mehrere nach innen gerichtete Gasauslässe 26, 27 hat. Zum Substrat 11 gelangt somit Gas einerseits vom Gaseinlaß 3, andererseits von den Gasauslässen 26, 27.

Im unteren Teil der Figur 4 ist eine Alternative zur Ringleitung 25 dargestellt. Diese besteht in der Ausbildung eines Ringkanals 28 auf der Innenmantelfläche der Außenmaskierung 13. Auch dieser Ringkanal 28 hat radial nach innen gerichtete Gasauslässe 29, 30.

Es sei abschließend bemerkt, daß die Ausführungsbeispiele Kathodenzerstäubungsanlagen mit jeweils zwei einander gegenüberliegenden Kathoden 6, 7 in der Kathodenstation 2 zeigen. Wenn ein Substrat nur von einer Seite beschichtet werden soll, was beispielsweise bei magnetooptischen Speicherplatten der Fall ist, dann kann man bei der erfindungsgemäßen Kathodenzerstäubungsanlage in jeder Kathodenstation 2 nur eine Kathode 6 vorsehen, so daß die Kathodenstation durch Weglassen der Kathode 7 entsprechend kompakter baut.

### Bezugszeichenliste

- 1: Außengehäuse
- 2: Kathodenstation
- 3: Gaseinlaß
- 4: Achse
- 5: Gasauslaß

- 6: Kathode
- 7: Kathode
- 8: Target
- 9: Target
- 10: Substrathalter

- 11: Substrat
- 12: Außenmaskierung
- 13: Außenmaskierung
- 14: Strömungskanal
- 15: Strömungskanal
- 16: Isolator
- 17: Isolator
- 18: Isolator
- 19: Isolator
- 20: Strömungskanal

- 21: Strömungskanal
- 22: Gaszuführbohrung
- 23: Gaszuführbohrung
- 24: Leitung
- 25: Ringleitung

- 26: Gasauslaß
- 27: Gasauslaß
- 28: Ringkanal
- 29: Gasauslaß
- 30: Gasauslaß

## Patentansprüche

1. Kathodenzerstäubungsanlage mit zumindest einer von einem Außengehäuse begrenzten, als Vakuumkammer ausgebildeten, zumindest eine Kathode (6, 7) mit einem Target (8, 9) aufweisenden Kathodenstation (2), in welcher ein Substrathalter (10) zum Halten eines zu beschichtenden Substrats (11), beispielsweise einer Datenspeicherdisk, vorgesehen ist und die zumindest einen Gaseinlaß (3) und zumindest einen mit einer Vakuumpumpe zu verbindenden Gasauslaß (5) aufweist, **dadurch gekennzeichnet**, daß der Gaseinlaß (3), der Substrathalter (10) und der Gasauslaß (5) auf einer gemeinsamen Achse (4) oder daß mehrere Gaseinlässe (3a, 3b) und/oder Gasauslässe (5a, 5b) symmetrisch zu der Achse (4) des Substrathalters (10) angeordnet sind.

2. Kathodenzerstäubungsanlage nach Anspruch 1, **dadurch gekennzeichnet**, daß in der Kathodenstation (2) zu beiden Seiten des Substrathalters (10) jeweils eine Kathode (6, 7) mit einem Target (8, 9) angeordnet ist.

3. Kathodenzerstäubungsanlage nach den Ansprüchen 1 oder 2, **dadurch gekennzeichnet**, daß zwischen einer Außenmaskierung (12, 13) der Kathode (6, 7) und dem Außengehäuse (1) ein zum vom Substrathalter (10) gehaltenen Substrat (11) führender, ringförmiger Strömungskanal (14, 15) gebildet ist.

4. Kathodenzerstäubungsanlage nach Anspruch 3, **dadurch gekennzeichnet**, daß für die Gaszuführung innerhalb der Kathodenstation (2) zusätzlich zum Strömungskanal (14, 15) auf der Außenseite der Kathodenmaskierung (12, 13) zwischen der Kathode (6, 7) und der Kathodenmaskierung (12, 13) ein innerer Strömungskanal (20, 21) gebildet ist.

5. Kathodenzerstäubungsanlage nach zumindest einem der vorangehenden Ansprüche, **dadurch gekennzeichnet,** daß mittig durch die Kathode (6, 7) und ihrem Target (8, 9) hindurch eine mit dem Gaseinlaß (3, 3c) strömungsmäßig verbundene Gaszuführbohrung (22, 23) verläuft.

6. Kathodenzerstäubungsanlage nach Anspruch 5, **dadurch gekennzeichnet,** daß der Gaseinlaß (3) mit der Gaszuführbohrung (22) und den ringförmigen Strömungskanälen (14, 15; 20, 21) Verbindung hat.

7. Kathodenzerstäubungsanlage nach zumindest einem der vorangehenden Ansprüche, **dadurch gekennzeichnet,** daß koaxial zur Achse (4) auf einem gemeinsamen Teilkreis zwischen dem Target (8, 9) und dem Substrathalter (10) mehrere Gasauslässe (26, 27; 29, 30) vorgesehen sind.

8. Kathodenzerstäubungsanlage nach Anspruch 6, **dadurch gekennzeichnet,** daß die Gasauslässe (26, 27) an einer koaxial zur Achse (4) angeordneten Ringleitung (25) vorgesehen sind.

9. Kathodenzerstäubungsanlage nach Anspruch 8, **dadurch gekennzeichnet,** daß die Gasauslässe (29, 30) an einem koaxial zur Achse (4) auf der Innenmantelfläche der Außenmaskierung (13) ausgebildeten Ringkanal (28) vorgesehen sind.

## Claims

1. Cathode sputtering apparatus comprising at least one cathode bay (2) which is defined by an outer housing, is formed as a vacuum chamber and has at least one cathode (6, 7) with a target (8, 9), in which a substrate holder (10) for holding a substrate (11) to be coated, e.g. a data storage disk is provided and which has at least one gas inlet (3) and at least one gas outlet (5) to be connected to a vacuum pump, characterised in that the gas inlet (3), the substrate holder (10) and the gas outlet (5) are disposed on a common axis (4) or that a plurality of gas inlets (3a, 3b) and/or gas outlets (5a, 5b) are disposed symmetrically about the axis (4) of the substrate holder (10).

2. Cathode-sputtering apparatus according to claim 1, characterised in that in the cathode bay (2) on either side of the substrate holder (10) a respective cathode (6, 7) with a target (8, 9) is disposed.

3. Cathode-sputtering apparatus according to claims 1 or 2, characterised in that between an outer mask (12, 13) of the cathode (6, 7) and the outer housing (1) an annular flow channel (14) is formed which leads to the substrate held by the substrate holder (10).

4. Cathode-sputtering apparatus according to claim 3, characterised in that for supplying gas inside the cathode bay (2) in addition to the flow channel (14, 15) an inner flow channel (20, 21) is formed on the outside of the cathode mask (12, 13) between the cathode (6, 7) and the cathode mask (12, 13).

5. Cathode-sputtering apparatus according to at least one of the preceding claims, characterised in that a gas supply bore (22, 23) connected to the gas inlet (3, 3c) extends centrally through the cathode (6, 7) and its target (8, 9).

6. Cathode-sputtering apparatus according to claim 5, characterised in that the gas inlet (3) communicates with the gas supply bore (22) and the annular flow channels (14, 15; 20, 21).

7. Cathode-sputtering apparatus according to at least one of the preceding claims, characterised in that coaxial to the axis (4) on a common semicircle between the target (8, 9) and the substrate holder (10) a plurality of gas outlets (26, 27; 29, 30) are provided.

8. Cathode-sputtering apparatus according to claim 6, characterised in that the gas outlets (26, 27) are provided on an annular line (25) disposed coaxial to the axis (4).

9. Cathode-sputtering apparatus according to claim 8, characterised in that the gas outlets (29, 30) are provided on an annular channel (28) formed coaxial to the axis (4) on the inner surface of the outer mask (13).

## Revendications

1. Installation de pulvérisation cathodique comportant au moins une station cathodique (2) qui est limitée par une enveloppe extérieure, est conçue en tant que chambre à vide, présente au moins une cathode (6, 7) avec une cible (8, 9), dans laquelle un porte-substrat (10) est prévu pour porter un substrat (11) à revêtir, par exemple un disque pour mémorisation de données et qui présente au moins une entrée de gaz (3) et au moins une sortie de gaz (5) à relier avec une pompe à vide, caractérisée par le fait que l'entrée de gaz (3), le porte-substrat (10) et la sortie (5) sont disposés sur un axe commun (4) ou que plusieurs entrées de gaz (3a, 3b) et/ou plusieurs sorties de gaz (5a, 5b) sont disposées symétriquement par rapport à l'axe (4) du porte-substrat (10).

2. Installation de pulvérisation cathodique selon la revendication 1, caractérisée par le fait que dans la station cathodique (2), une cathode (6, 7) avec une cible (8, 9) est disposée de chacun des deux côtés du porte-substrat (10).

3. Installation de pulvérisation cathodique selon les revendications 1 ou 2, caractérisée par le fait qu'entre un masque extérieur (12, 13) de la cathode (6, 7) et l'enveloppe extérieure (1) est formé un canal annulaire d'écoulement (14, 15) qui conduit au substrat (11) porté par le porte-substrat (10).

4. Installation de pulvérisation cathodique selon la revendication 3, caractérisée par le fait que pour l'amenée du gaz à l'intérieur de la station cathodique (2), en plus du canal d'écoulement (14, 15) prévu à l'extérieur du masque (12, 13) de la cathode, un canal d'écoulement intérieur (20, 21) est formé entre la cathode (6, 7) et le masque (12, 13) de la cathode.

5. Installation de pulvérisation cathodique selon au moins l'une des revendications précédentes, caractérisée par le fait qu'un perçage d'amenée du gaz (22, 23), relié à l'entrée de gaz (3, 3c) au point de vue écoulement, passe à travers la cathode (6, 7) et sa cible (8, 9).

6. Installation de pulvérisation cathodique selon la revendication 5, caractérisée par le fait que l'entrée de gaz (3) est reliée au perçage (22) d'amenée du gaz et aux canaux annulaires d'écoulement (14, 15; 20, 21).

7. Installation de pulvérisation cathodique selon au moins l'une des revendications précédentes, caractérisée par le fait que coaxialement à l'axe (4), plusieurs sorties de gaz (26, 27; 29, 30) sont prévues sur un cercle partiel commun entre la cible (8, 9) et le porte-substrat (10).

8. Installation de pulvérisation cathodique selon la revendication 6, caractérisée par le fait que les sorties du gaz (26, 27) sont prévues sur une conduite annulaire (25) disposée coaxialement à l'axe (4).

9. Installation de pulvérisation cathodique selon la revendication 8, caractérisée par le fait que les sorties du gaz (29, 30) sont prévues sur un canal annulaire (28) formé, coaxialement à l'axe (4), sur la surface latérale intérieure du masque extérieur (13).
